# EUROPEAN PATENT APPLICATION

(11) **EP 4 760 779 A1**
(43) Date of publication of application: **17.06.2026**
(21) Application number: 23948560.0
(22) Date of filing: 01.12.2023
(51) Int. Cl.: H01L 21/677, F04B 41/00, F04C 29/00

(54) **VACUUM GENERATOR AND LOAD PORT**

(30) Priority: 08.08.2023 US 202363531538 P
(71) Applicant: Minebea Mitsumi Inc., Kitasaku-gun, Nagano 3890293 (JP)
(72) Inventor: KITANO, Tomoaki, Kitasaku-gun, Nagano 389-0293 (JP); NISHIBU, Koki, Kitasaku-gun, Nagano 389-0293 (JP); SHIMOHATA, Takeshi, Kitasaku-gun, Nagano 389-0293 (JP); NAGASHIMA, Tatsuhiro, Kitasaku-gun, Nagano 389-0293 (JP); NISHIHASHI, Susumu, Kitasaku-gun, Nagano 389-0293 (JP); IKEMOTO, Takeshi, Kitasaku-gun, Nagano 389-0293 (JP)
(74) Representative: Winter, Brandl - Partnerschaft mbB
(86) International application number: PCT/JP2023/043196
(87) International publication number: WO 2025/032849

(57) **Abstract**

A vacuum generator (10) includes: a mounting member (500); and a suction device (100) including a vacuum pump (160) connected to the mounting member (500). The mounting member (500) includes a suction space (600) and a solenoid valve (800). The mounting member (500) connects the vacuum pump (160) to a tube (670) connected to a suction target (951, 952). The solenoid valve (800) enables a suction path (700) including the tube (670) and the suction space (600) to be open to the atmosphere.

## Description

### Technical Field

The present invention relates to a vacuum generator and a load port.

### Background Art

It is known that a vacuum generator is used as opening/closing means or suction means in a load port or the like used for semiconductor manufacturing. As the vacuum generator, for example, technology using a vacuum ejector is known.

### Citation List

### Patent Literature

Patent Document 1: JP 05-215089 A
Patent Document 2: JP 2014-241333 A

### Summary of Invention

### Technical Problem

When the vacuum ejector is used, an external large compressor needs to be connected to the vacuum ejector. In this case, air leakage from a pipe connected to the large compressor, a pipe branched to another load port, or the like, or air leakage when the vacuum generator converts positive pressure to negative pressure may increase. Such air leakage causes noise and an increase in power consumption.

In one aspect, an object is to provide a vacuum generator and a load port capable of reducing air leakage.

### Solution to Problem

In one aspect, a vacuum generator includes: a mounting member; and a suction device including a vacuum pump connected to the mounting member. The mounting member includes a suction space and a solenoid valve. The mounting member connects the vacuum pump to a tube connected to a suction target. The solenoid valve enables a suction path including the tube and the suction space to the atmosphere.

According to one aspect, air leakage can be reduced.

### Brief Description of Drawings

FIG. 1A is a back view illustrating an example of a load port according to an embodiment.
FIG. 1B is a side view illustrating an example of the load port according to the embodiment.
FIG. 1C is a front view illustrating an example of the load port according to the embodiment.
FIG. 2 is a side view illustrating an example of a vacuum generator mounted to the load port according to the embodiment.
FIG. 3 is a front view illustrating an example of the vacuum generator according to the embodiment.
FIG. 4 is a perspective view illustrating an example of the vacuum generator according to the embodiment.
FIG. 5 is a perspective view illustrating an example of a support member according to the embodiment.
FIG. 6 is an exploded perspective view illustrating an example of a cartridge according to the embodiment.
FIG. 7 is a perspective view illustrating an example of a cover of the cartridge according to the embodiment.
FIG. 8 is a perspective view illustrating an example of the cartridge according to the embodiment.
FIG. 9 is a perspective view illustrating an example of a bottom part of the cartridge according to the embodiment.
FIG. 10 is a cross-sectional view illustrating an example of a first ventilation path according to the embodiment.
FIG. 11 is a perspective view illustrating an example of the first ventilation path and a second ventilation path according to the embodiment.
FIG. 12 is a top view illustrating an example of a slot of a mounting member according to the embodiment.
FIG. 13 is a side view illustrating an example of a state where the cartridge is removed from the vacuum generator mounted to the load port according to the embodiment.
FIG. 14 is a cross-sectional view illustrating an example of the vacuum generator according to the embodiment.
FIG. 15 is a cross-sectional view illustrating another example of the vacuum generator according to the embodiment.

### Description of Embodiments

Hereinafter, an embodiment of a vacuum generator and a load port disclosed in the present application will be described in detail based on the drawings. Note that the dimensional relationship between elements and the ratio of each element in the drawings may differ from reality. Differences in dimensional relationship and ratio may be included between the drawings. In the drawings, a coordinate system with a top surface 111 side of a cartridge 100 described below defined as a positive direction of a Y-axis may be illustrated for the sake of clarity of description. Note that throughout the description of the embodiment, the same components are denoted by the same reference numerals.

### Embodiment

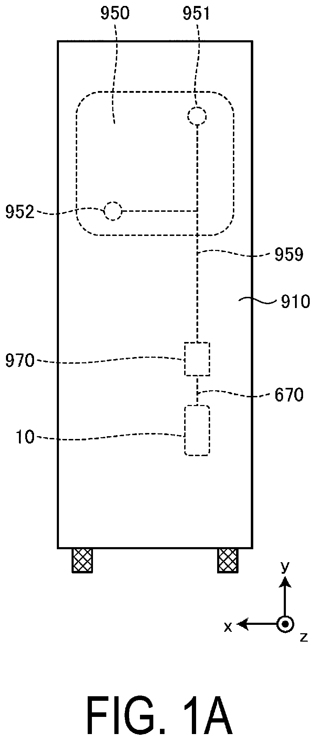

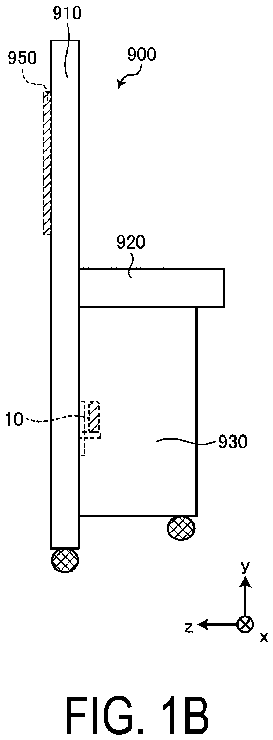

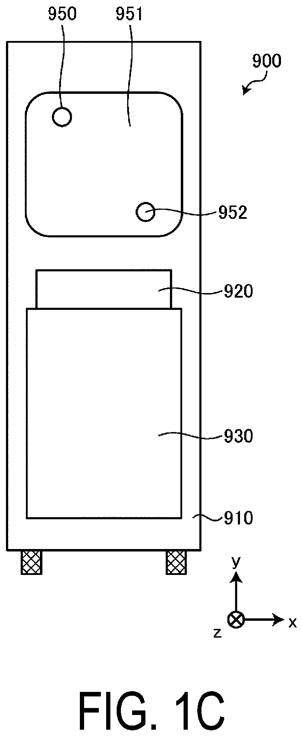

A vacuum generator according to an embodiment is used in semiconductor manufacturing equipment, for example, a load port as illustrated in FIG. 1. FIGS. 1A to 1C are a three-view drawing illustrating an example of a load port according to the embodiment. FIG. 1A is a back view of a load port 900, FIG. 1B is a side view of the load port 900, and FIG. 1C is a front view of the load port 900. As illustrated in FIG. 1, the load port 900 according to the embodiment includes a wall part 910 including an opening/closing part 950, a table 920 mounted with a front opening unified pod (FOUP: not illustrated) housing semiconductor wafers, and an interior space 930. In addition, suction parts 951 and 952 are formed in the opening/closing part 950. Note that the load port 900 may include a pressure sensor (not illustrated) or the like.

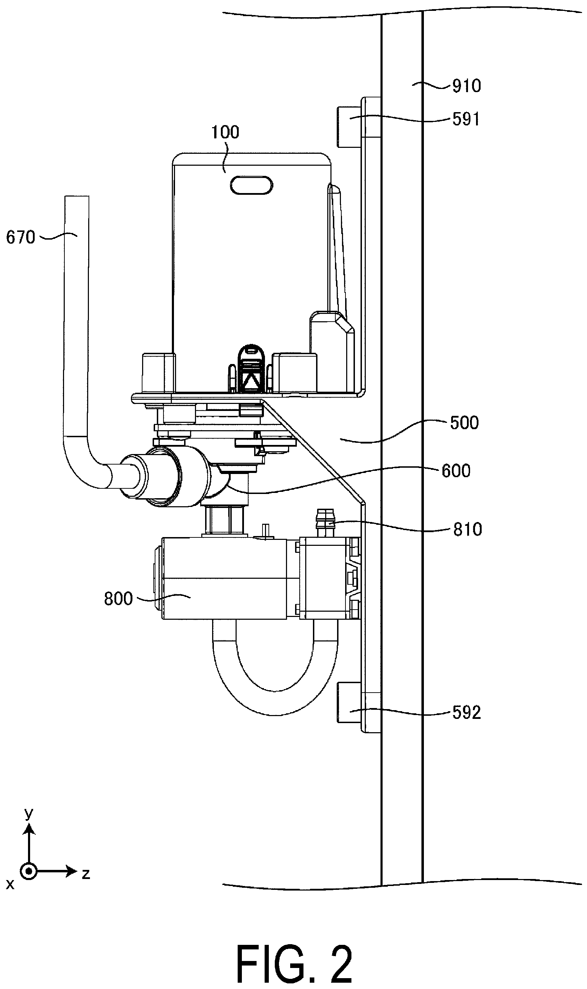

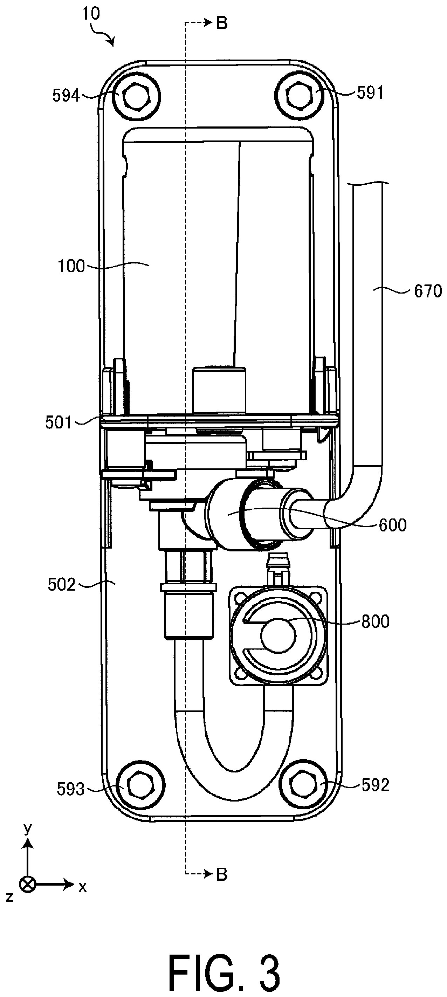

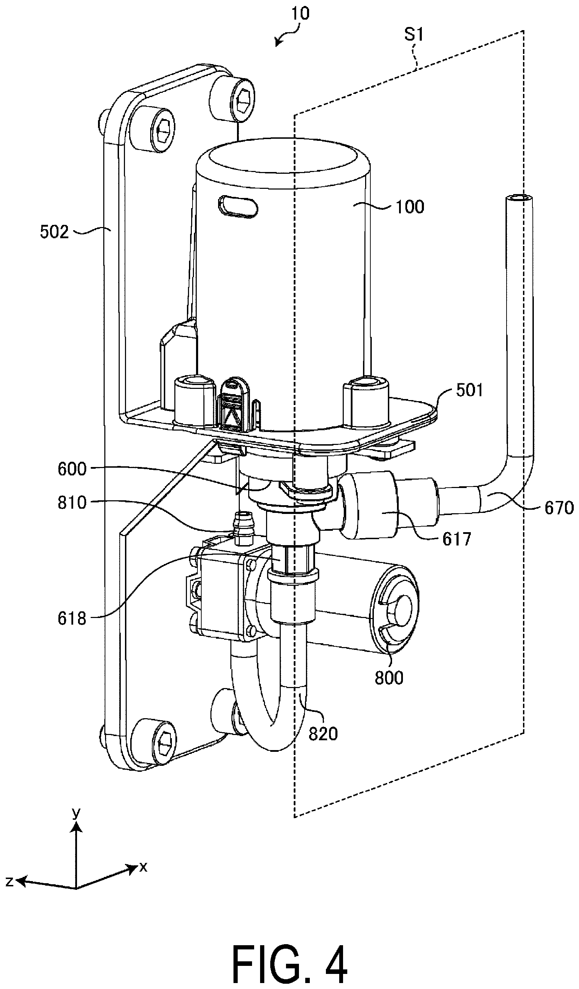

The suction parts 951 and 952 of the load port 900 are sucked by, for example, a vacuum generator 10 as illustrated in FIGS. 2 to 4 to suck a door of the FOUP and perform an opening/closing operation or the like. FIG. 2 is a side view illustrating an example of the vacuum generator mounted to the load port according to the embodiment. FIG. 3 is a front view illustrating an example of the vacuum generator according to the embodiment. FIG. 4 is a perspective view illustrating an example of the vacuum generator according to the embodiment. For example, as illustrated in FIGS. 1 and 2, the vacuum generator 10 illustrated in FIGS. 3 and 4 is mounted to the wall part 910 in a form of being housed in the interior space 930 of the load port 900, and is connected to a pipe connection part 970 of the load port 900 via a tube 670. As illustrated in FIG. 1, the pipe connection part 970 is connected to the suction parts 951 and 952 via a pipe 959. The suction parts 951 and 952 of the load port 900 are examples of suction targets.

As illustrated in FIG. 2, the vacuum generator 10 according to the embodiment includes a mounting member 500 and a cartridge 100. Note that the cartridge 100 is an example of a suction device.

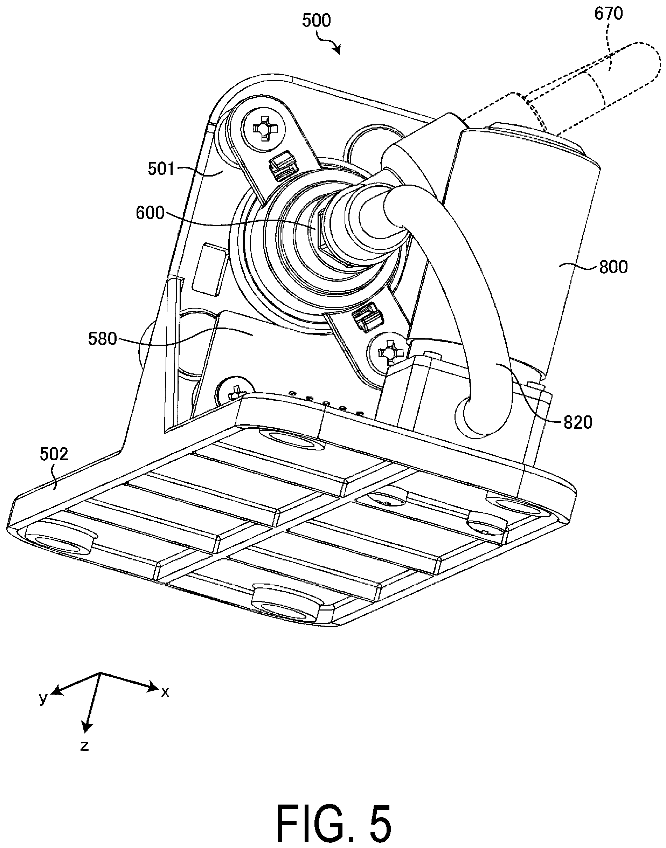

As illustrated in FIG. 5, the mounting member 500 includes a support surface 501 and a mounting surface 502. FIG. 5 is a perspective view illustrating an example of the support member according to the embodiment. The mounting surface 502 of the mounting member 500 is fixed to the wall part 910 of the load port 900 as illustrated in FIG. 2 by, for example, bolts 591 to 594 such as M6 cap bolts as illustrated in FIG. 3. As illustrated in FIGS. 3 and 4, the cartridge 100 is mounted to the support surface 501 of the mounting member 500. Further, the mounting member 500 includes a suction space 600 described below and a solenoid valve 800 described below. As illustrated in FIG. 5, the solenoid valve 800 is fixed to the mounting surface 502 of the mounting member 500, and the suction space 600 is fixed to the support surface 501. Furthermore, as illustrated in FIG. 5, a substrate 580 described below is also fixed to the support surface 501.

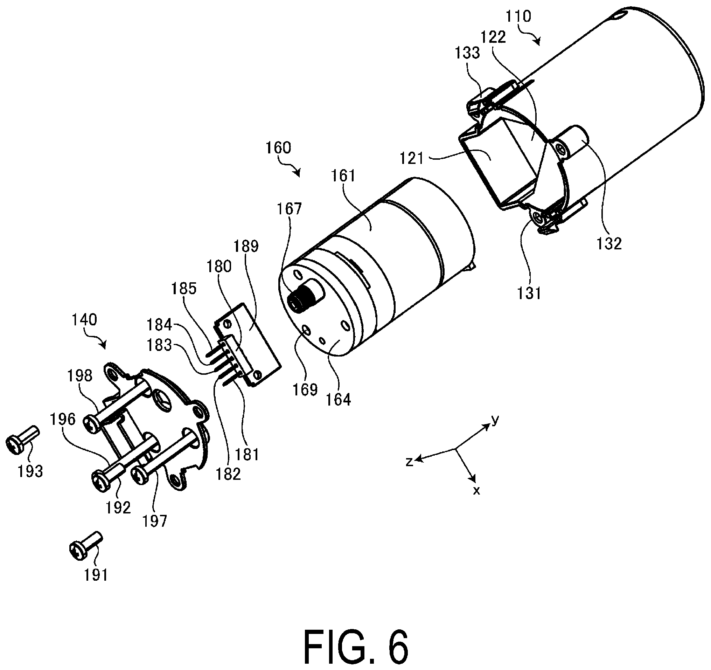

The air in the suction space 600 of the mounting member 500 is sucked by a vacuum pump 160 included in the cartridge 100 illustrated in FIG. 6. FIG. 6 is an exploded perspective view illustrating an example of the cartridge according to the embodiment. As illustrated in FIG. 6, the cartridge 100 according to the embodiment includes a cover 110, a bottom part 140, the vacuum pump 160, a terminal block 180, and a substrate 189. The vacuum pump 160 is housed in the cover 110 and the bottom part 140 while being fixed to the bottom part 140 by bolts 196 to 198 illustrated in FIG. 6.

The vacuum pump 160 includes a side surface 161 and a bottom surface 164. The bottom surface 164 includes a suction hole 167 and a discharge hole 169 illustrated in FIG. 6. The vacuum pump 160 sucks the air from the suction hole 167 and discharges the air from the discharge hole 169, for example, by a motor rotating an impeller or the like.

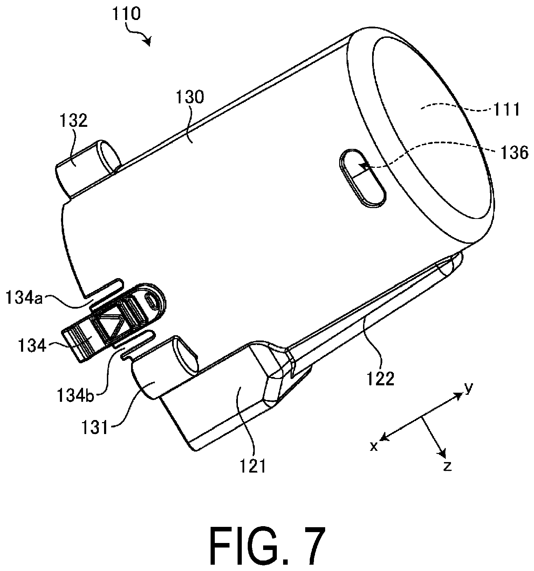

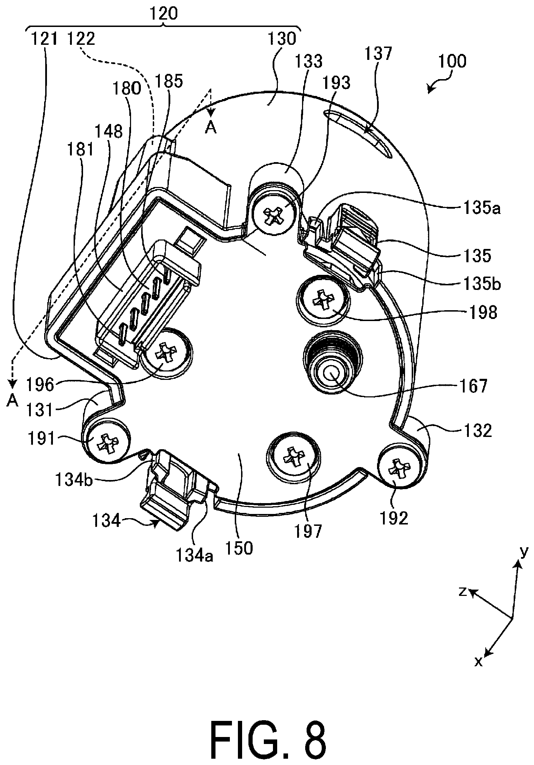

The cover 110 includes a top surface 111 illustrated in FIG. 7 and a side surface 120 illustrated in FIG. 8. FIG. 7 is a perspective view illustrating an example of the cover of the cartridge according to the embodiment. FIG. 8 is a perspective view illustrating an example of the cartridge according to the embodiment. The top surface 111 is formed at a position opposed to the bottom part 140 illustrated in FIG. 6 in the Y-axis direction. As illustrated in FIG. 8, the side surface 120 of the cover 110 includes a housing part 121, a ventilation part 122, and a curved surface 130. The terminal block 180 and the substrate 189 illustrated in FIG. 6 are housed in the housing part 121. The housing part 121 and the ventilation part 122 protrude outward in a radial direction, that is, in a direction intersecting with the mounting direction with respect to the mounting member 500.

The curved surface 130 of the cover 110 includes boss parts 131 to 133 protruding outward in the radial direction. As illustrated in FIGS. 6 and 8, the boss parts 131 to 133 are fixed to the bottom part 140 by bolts 191 to 193, respectively.

A pair of claw parts 134 and 135 are formed at the curved surface 130. As illustrated in FIG. 7, the claw parts 134 and 135 protrude from the bottom part 140 toward the negative direction side of the Y axis. In addition, as illustrated in FIGS. 7 and 8, slits 135a and 135b are formed at both sides of the claw part 135 in a circumferential direction. As illustrated in FIG. 8, the claw part 134 is also formed with slits 134a and 134b. Note that the number of claw parts is not limited to one pair, and in addition to the claw parts 134 and 135, other claw parts may be formed.

As illustrated in FIGS. 7 and 8, the curved surface 130 has exhaust ports 136 and 137 formed at the top surface 111 side in the Y-axis direction.

As illustrated in FIG. 6, the terminal block 180 holds a plurality of terminals 181 to 185 electrically connecting the substrate 580 of the mounting member 500 and the cartridge 100. The substrate 189 electrically connects the substrate 580 illustrated in FIG. 5 and the vacuum pump 160 via the terminals 181 to 185.

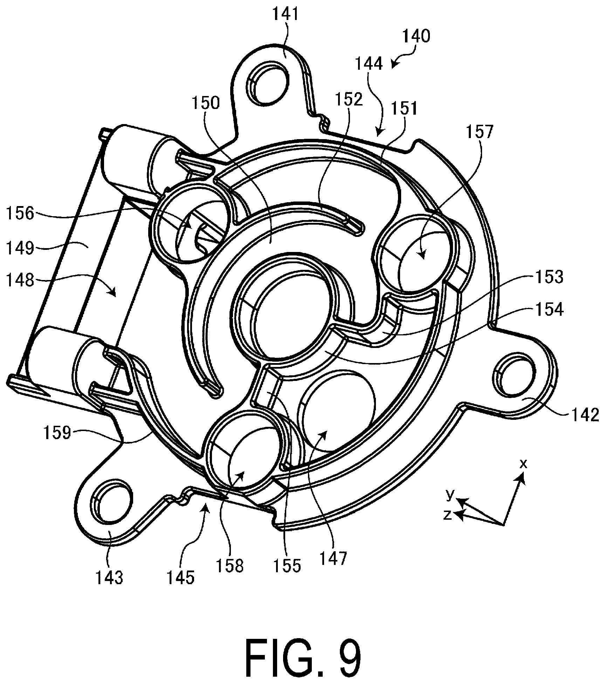

Further, in the embodiment, as illustrated in FIG. 9, the bottom part 140 has protruding parts 141 to 143 formed at positions opposed to the boss parts 131 to 133 of the cover 110. FIG. 9 is a perspective view illustrating an example of the bottom part of the cartridge according to the embodiment. Through holes inserted through with the bolts 191 to 193 are formed in the protruding parts 141 to 143, respectively. Furthermore, as illustrated in FIG. 9, through holes 156 to 158 inserted through with the bolts 196 to 198 are formed in the bottom part 140.

In addition, the bottom part 140 includes a bottom surface 150 and sidewalls 151 to 155 and 159 protruding toward the positive direction side in the Y-axis direction and extending in a direction intersecting with the Y-axis direction.

Further, as illustrated in FIG. 9, recessed parts 144 and 145 are respectively formed in the bottom part 140 at positions corresponding to the claw parts 134 and 135 of the cover 110. The claw parts 134 and 135 of the cover 110 can be elastically deformed inward in the radial direction by the slits 134a, 134b, 135a, and 135b and the recessed parts 144 and 145 of the bottom part 140.

Furthermore, the bottom part 140 includes a through hole 148 inserted through with the terminal block 180, and a support part 149 supporting the substrate 189. In the embodiment, the support part 149 is arranged at a section protruding outward in the radial direction. Thus, the substrate 189 is arranged at the protruding section. In addition, a through hole 147 inserted through with the suction hole 167 is formed in the bottom part 140.

Further, the air sucked by the vacuum pump 160 of the cartridge 100 is discharged from the discharge hole 169 of the vacuum pump 160 illustrated in FIG. 6. When being discharged from the exhaust ports 136 and 137 formed in the cover 110, the discharged air passes through a first ventilation path formed by the sidewalls 151 to 155 and 159 of the bottom part 140.

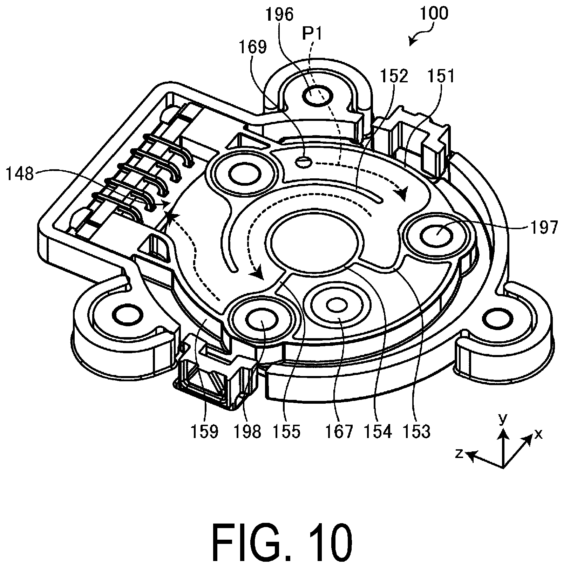

The sidewalls 151 to 155 and 159 illustrated in FIG. 9 form a first ventilation path P1 like a series of arcs as illustrated in FIG. 10. FIG. 10 is a cross-sectional view illustrating an example of the first ventilation path according to the embodiment. FIG. 10 illustrates a cross-section taken along the line A-A in FIG. 8. As illustrated in FIG. 10, the first ventilation path P1 continues from the discharge hole 169 of the vacuum pump 160 to the through hole 148 arranged in with the terminal block 180 while repeating turnback.

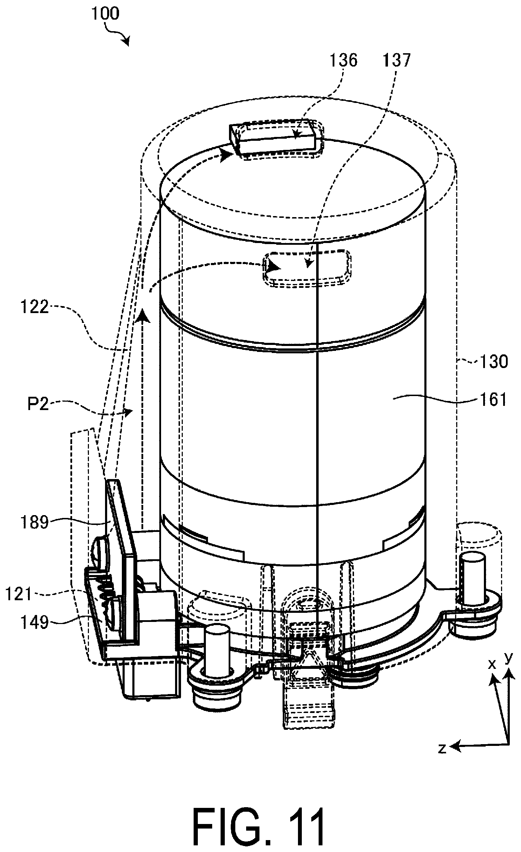

In addition, as illustrated in FIG. 11, the first ventilation path P1 is formed by the bottom surface 150 and the sidewalls 151 to 155 and 159 of the bottom part 140, and the bottom surface 164 of the vacuum pump 160. FIG. 11 is a perspective view illustrating an example of the first ventilation path and a second ventilation path according to the embodiment. Then, as indicated by the arrows in FIG. 11, the air discharged from the first ventilation path P1 passes through the ventilation part 122 leading to the exhaust ports 136 and 137 while contacting the substrate 189 supported by the support part 149 in the housing part 121. At this time, the air is discharged from the exhaust ports 136 and 137 while contacting the side surface 161 of the vacuum pump 160 and the ventilation part 122 and the curved surface 130 of the cover 110. In other words, as illustrated in FIG. 11, a second ventilation path P2 is formed by the ventilation part 122, the curved surface 130, and the side surface 161 of the vacuum pump 160.

According to this configuration, a path of the air discharged from the discharge hole 169 to the outside of the cartridge 100 can be lengthened, and thus exhaust sound can be reduced. In addition, the substrate 189 is arranged in the path of exhaust air, and the exhaust air is discharged along the side surface 161 of the vacuum pump 160. Therefore, the exhaust air can be utilized for cooling the vacuum pump 160 and the substrate 189.

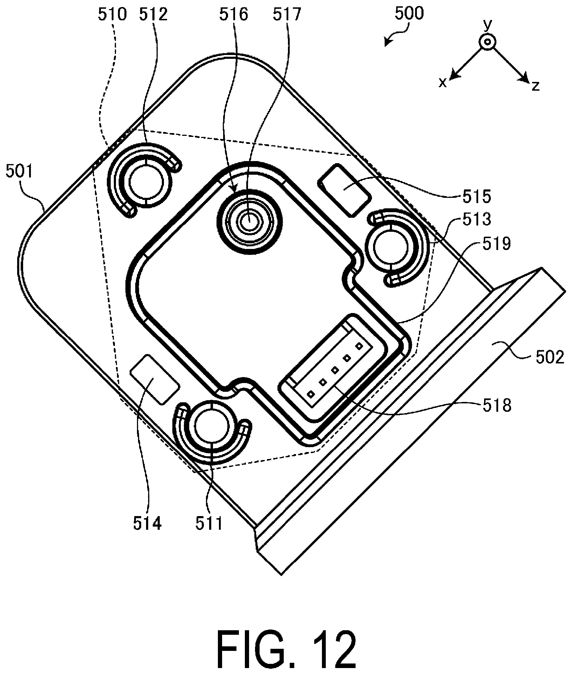

The cartridge 100 is fixed to the support surface 501 of the mounting member 500. As illustrated in FIG. 12, a slot 510 is formed in the support surface 501. The cartridge 100 is mounted in the slot 510. FIG. 12 is a top view illustrating an example of the slot of the mounting member according to the embodiment. As illustrated in FIG. 12, the slot 510 includes support walls 511 to 513, engaged parts 514 and 515, an opening 516, and a connector 518. For example, as illustrated in FIG. 12, the engaged parts 514 and 515 are through holes formed in the support surface 501 of the mounting member 500, and are formed at positions opposed to the claw parts 134 and 135 of the cartridge 100. The connector 518 is connected to, for example, the substrate 580 illustrated in FIG. 5. A connection port 517 connecting to the suction space 600 protrudes from the opening 516 toward the positive direction side of the Y axis.

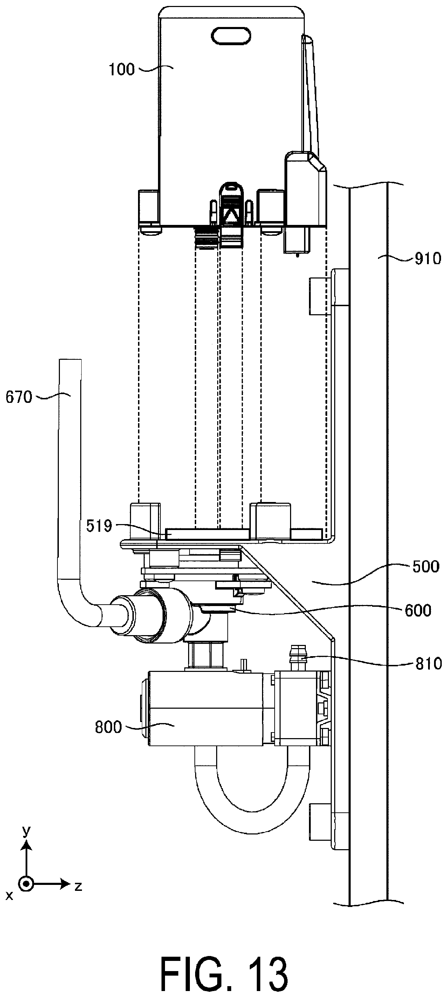

As illustrated in FIG. 13, the cartridge 100 can be mounted to the mounting member 500 or removed from the mounting member 500 in a state where the vacuum generator 10 is fixed to the wall part 910 of the load port 900. FIG. 13 is a side view illustrating an example of a state where the cartridge is removed from the vacuum generator mounted to the load port according to the embodiment. That is, the cartridge 100 can be removed in a state where the vacuum generator 10 is connected to the tube 670. As illustrated in FIG. 13, the cartridge 100 is mounted from the positive direction side in the Y-axis direction, that is, from the top surface side of the slot 510 of the mounting member 500 illustrated in FIG. 12, and is removed toward the positive direction side in the Y-axis direction.

The claw parts 134 and 135 of the cartridge 100 are respectively inserted into the engaged parts 514 and 515 formed in the support surface 501 of the mounting member 500 illustrated in FIG. 12, in a state of being elastically deformed inward in the radial direction. Thereafter, the claw parts 134 and 135 return to the outer side in the radial direction, and thus the claw parts 134 and 135 respectively engage with the engaged parts 514 and 515. As a result, the cartridge 100 is mounted to the mounting member 500. In this case, the support walls 511 to 513 serve as guide parts for positioning the boss parts 131 to 133.

A distal end part of the claw part 135 of the cartridge 100 extends to the negative direction side in the Y axis direction and engages with the engaged part 515 of the slot 510 illustrated in FIG. 12. In this case, the cartridge 100 and the mounting member 500 are engaged with each other by the claw part 135 and the engaged part 515. Note that the claw part 135 and the engaged part 515 constitute an engagement mechanism. The same applies to the claw part 134 and the engaged part 514. Note that the engagement mechanism is not limited to a mechanism using a claw, and may provide, for example, engagement by screwing.

At this time, the terminals 181 to 185 of the cartridge 100 extend toward the negative direction side in the Y-axis direction and are connected to the connector 518. When the cartridge 100 is mounted in the slot 510, the suction hole 167 protruding toward the negative direction side of the Y axis is inserted into the connection port 517 of the mounting member 500. In this case, the terminal 184 of the cartridge 100 and the connector 518 of the mounting member 500, and the suction hole 167 of the cartridge 100 and the connection port 517 of the mounting member 500 are connected to each other on the same surface as the surface where the claw part 134 and the engaged part 514 constituting the engagement mechanism are engaged with each other.

In addition, as illustrated in FIGS. 12 and 13, the slot 510 of the mounting member 500 is provided with a seal packing 519. In the support surface 501, the connection port 517 and the connector 518 are surrounded by the seal packing 519 as illustrated in FIG. 12. In other words, in a state where the cartridge 100 is mounted to the mounting member 500, the seal packing 519 surrounds the terminals 181 to 185, the connector 518, the suction hole 167, and the connection port 517. According to such a configuration, vibration propagation between the cartridge 100 and the mounting member 500 is suppressed and foreign matter contamination or water immersion into the slot 510 is suppressed, and thus durability of the connection part between the cartridge 100 and the slot 510 can be improved. In addition, the cartridge 100 and the slot 510 are closely attached to each other, and thus air leakage from the connection part can be suppressed.

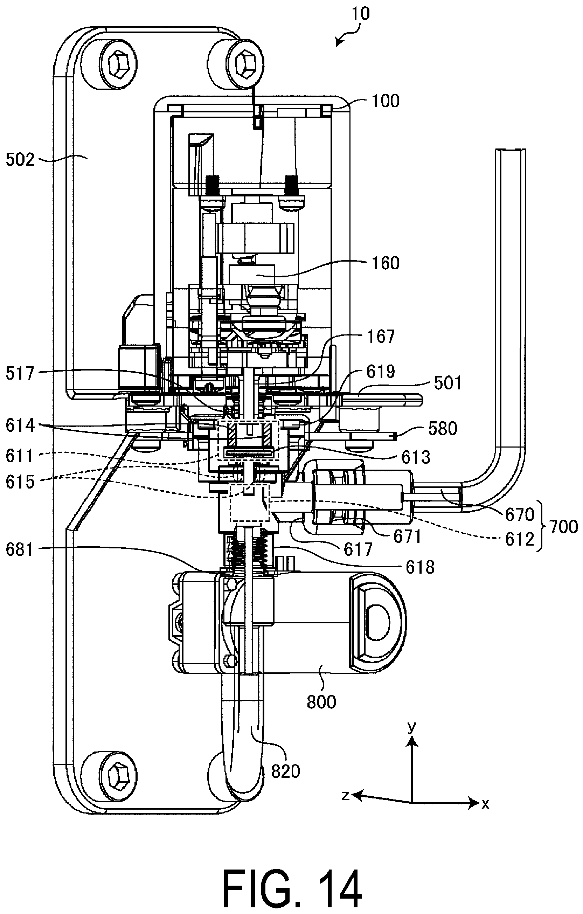

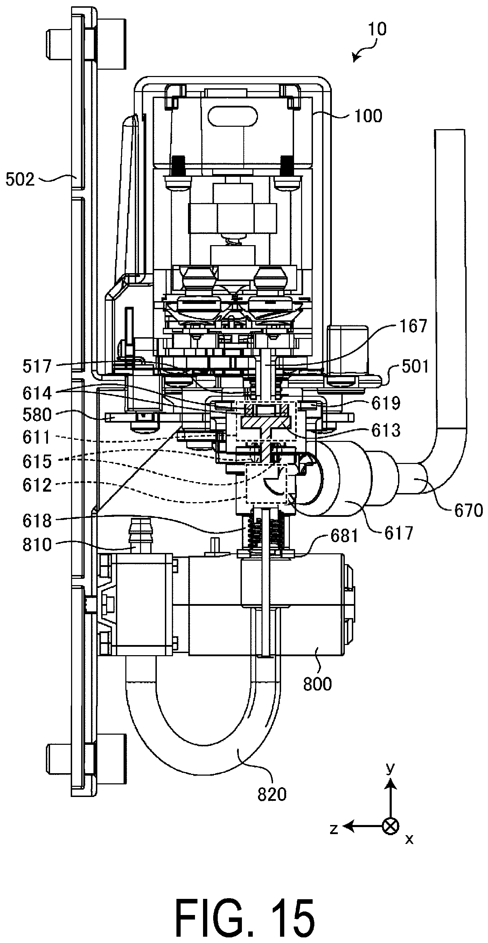

In a state where the cartridge 100 is mounted to the mounting member 500, the suction space 600 of the mounting member 500 is connected to the suction hole 167 of the cartridge 100 illustrated in FIGS. 14 and 15. FIG. 14 is a cross-sectional view illustrating an example of the vacuum generator according to the embodiment. FIG. 15 is a cross-sectional view illustrating another example of the vacuum generator according to the embodiment. FIG. 14 illustrates a cross-section taken along the line B-B in FIG. 3. FIG. 15 illustrates a cross-section taken along a plane S1 in FIG. 4.

As illustrated in FIGS. 14 and 15, the suction space 600 includes a first space 611 and a second space 612. The first space 611 is located at the positive direction side of the Y axis with respect to the second space 612, and is opposed to the second space 612 via a vent hole 615. The first space 611 and the second space 612 are switched between a communication state and a separation state by a check valve 613 described below. The first space 611 is connected to the suction hole 167 of the cartridge 100 via the connection port 517.

The connection port 517 is in close contact with the suction space 600 via a sealing member 619 such as an O-ring. In this case, a part of the suction space 600 surrounded by the connection port 517 forms the first space 611. Note that the sealing member 619 is not limited to the O-ring, and may be another sealing member capable of ensuring airtightness, such as a screw, a gasket, a packing, or fluorine tape.

A first opening 617 and a second opening 618 are provided in the second space 612 of the suction space 600. As illustrated in FIGS. 14 and 15, the first opening 617 is formed in a direction intersecting the Y axis with respect to the suction space 600, and the second opening 618 is formed at the negative direction side of the Y axis with respect to the suction space 600.

The tube 670 is connected to the first opening 617. The first opening 617 and the tube 670 are closely attached to each other by a sealing member 671 such as an O-ring. In this case, as illustrated in FIGS. 14 and 15, the suction space 600 connects the vacuum pump 160 of the cartridge 100 to the tube 670 connected to the suction parts 951 and 952 as the suction targets of the load port 900. In addition, the second space 612 of the suction space 600 and the tube 670 constitute a suction path 700.

As illustrated in FIGS. 14 and 15, the solenoid valve 800 is connected to the second opening 618. The solenoid valve 800 switches between an open state and a closed state of the second space 612 of the suction space 600. The closed state is a state where the solenoid valve 800 is closed. In this state, the vacuum pump 160 is driven, and thus pressure in the second space 612 becomes negative pressure. On the other hand, the open state of the solenoid valve 800 is a state where the solenoid valve 800 is open, and the suction path 700 including the tube 670 and the suction space 600 is open to the atmosphere. Thus, the pressure in the second space 612, being under the negative pressure shifts to atmospheric air pressure.

As illustrated in FIG. 15, the solenoid valve 800 is connected to an atmosphere opening port 810 via a tube 820. In addition, the second opening 618 and the solenoid valve 800 are closely attached to each other by a sealing member 681 such as a flat packing illustrated in FIGS. 14 and 15.

The substrate 580 connects a power supply (not illustrated) to the solenoid valve 800 and the cartridge 100. The substrate 580 according to the embodiment executes a function as a control unit, for example, by executing a program stored in a storage device (not illustrated). In addition, the substrate 580 may control starting and stopping of the vacuum pump 160 and the solenoid valve 800 in accordance with an instruction from an external device (not illustrated) such as the load port 900. In other words, the substrate 580 controls starting and stopping of the vacuum pump 160 and closing and opening of the solenoid valve 800.

As illustrated in FIGS. 14 and 15, the suction space 600 allowing passage of the air sucked by the cartridge 100 includes the check valve 613 allowing switching between the communication state and the separation state of the first space 611 and the second space 612 of the suction space 600. The check valve 613 is provided in the suction space 600, and switches between the communication state and the separation state of the first space 611 and the second space 612 by opening or closing the vent hole 615 of the suction space 600. In addition, as illustrated in FIGS. 14 and 15, the suction space 600 of the vacuum generator 10 includes a biasing member 614 such as a spring.

As illustrated in FIG. 14, the check valve 613 according to the embodiment is biased by the biasing member 614 toward the negative direction side in the Y-axis direction, that is, in a direction to close the vent hole 615. In this state, the check valve 613 brings the first space 611 and the second space 612 into the separation state. In other words, in the embodiment, the mounting member 500 includes the biasing member 614 biasing the check valve 613 in a direction toward the separation state. In addition, the biasing member 614 is not limited to a spring, and may be another member such as rubber, a magnet, a shape-memory alloy, or a disc-shaped bimetal (thermal expansion valve). For example, the disc-shaped bimetal can be appropriately applied according to the temperature of gas to be sucked.

On the other hand, as illustrated in FIGS. 14 and 15, when the air in the suction space 600 is sucked by the cartridge 100, the check valve 613 moves to the positive direction side in the Y-axis direction, that is, in the direction to open the vent hole 615 against biasing force of the biasing member 614. In this state, the check valve 613 brings the first space 611 and the second space 612 in communication with each other. In other words, in the embodiment, the check valve 613 is switched to the separation state in a state where the vacuum pump 160 of the cartridge 100 connected to the connection port 517 is stopped, and is switched to the communication state during the operation of the vacuum pump 160.

In addition, when the cartridge 100 stops operating, the check valve 613 returns to the separation state by the biasing force of the biasing member 614. In such a configuration, during the operation stopping of the cartridge 100, the entry of fluid from the cartridge 100 into the suction path 700 is suppressed. In addition, when the solenoid valve 800 is open during the operation stopping of the cartridge 100, the interior space of the cartridge 100 or the first space 611 of the suction space 600 is not open to the atmosphere, and only the suction path 700 is open to the atmosphere. On the other hand, when the solenoid valve 800 is in the closed state, the inside of the second space 612 is maintained at the negative pressure even when the vacuum pump 160 is stopped. The check valve 613 maintains the separation state even when the cartridge 100 is removed from the mounting member 500. In this case, when the solenoid valve 800 is shifted to the open state, the pressure inside the suction path 700 including the tube 670 returns to the atmospheric air pressure more quickly than when the first space 611 and the second space 612 are in communication with each other. As described above, by using the solenoid valve 800 and the check valve 613, the time to open the second space 612 to the atmosphere can be significantly shortened compared with natural opening to the atmosphere. Accordingly, the opening and closing operation by suction and separation of the suction parts 951 and 952 can be quickly repeated, and working process time can be reduced, leading to an improvement in production efficiency and an increase in the number of products manufactured per day. Note that in the embodiment, the substrate 580 does not directly control the operation of the check valve 613, and the check valve 613 operates in conjunction with the operation of the vacuum pump 160 or the solenoid valve 800.

In addition, in the embodiment, as illustrated in FIGS. 14 and 15, the second opening 618 connected to the solenoid valve 800, the check valve 613, and the connection port 517 are disposed in a straight line. For example, the check valve 613 is located at the negative direction side of the Y axis with respect to the connection port 517, and the second opening 618 is located at the negative direction side of the Y axis with respect to the check valve 613. In this case, the suction space 600 including the check valve 613 is located at the negative direction side of the Y axis with respect to the cartridge 100, and the solenoid valve 800 connected to the second opening 618 is retracted to the suction space 600 and located at the negative direction side of the Y axis. According to this configuration, the structure of the suction space 600 of the mounting member 500 can be simplified, and the mounting member 500 can be downsized.

In this configuration, the vacuum state of the second space 612 is released by the operation of the solenoid valve 800. Specifically, the solenoid valve 800 connected via the second opening 618 to the second space 612 is shifted from the closed state to the open state, and thus the second space 612 in the vacuum state is released to the atmosphere. According to this configuration, the vacuum state of the suction path 700 can be released without operating the check valve 613, and thus the structure can be simplified.

As described above, the vacuum generator 10 according to the embodiment includes the mounting member 500 and the suction device 100 including the vacuum pump 160 connected to the mounting member. The mounting member 500 includes the suction space 600 and the solenoid valve 800. The mounting member 500 connects the vacuum pump 160 to the tube 670 connected to the suction targets 951 and 952. The solenoid valve 800 enables the suction path 700 including the tube 670 and the suction space 600 to be open to the atmosphere. In addition, the load port 900 according to the embodiment is connected via the tube 670 to the vacuum generator 10, and includes the suction parts 951 and 952 connected to the tube 670. The suction device 100 in the load port 900 is removable in a state where the vacuum generator 10 is connected to the tube 670. According to this configuration, a pipe connected to an external large compressor or the like, a pipe branched from the large compressor to another load port, or the like is not required; therefore, air leakage from the pipe can be suppressed, and a structure used for vacuum generation can be downsized. In addition, unlike the case of using a vacuum ejector, in the case of using a vacuum pump, conversion from positive pressure to negative pressure does not occur, and it is not necessary to use a large compressor such as a compressor. Therefore, the size of the structure for generating vacuum can be reduced, and noise and power consumption can be reduced.

### Modified Examples

Although the configuration of each embodiment is described above, the embodiment is not limited to this configuration. For example, the vacuum generator 10 may be fixed to the back surface of the wall part 910 of the load port 900, that is, the outside of the interior space 930, or may be arranged outside the load port 900. Further, the cartridge 100 connected to the mounting member 500 may be connected to the slot 510 of the mounting member 500 so as to be separated from the slot 510 without being closely attached to the slot 510.

Furthermore, the vacuum generator 10 can be applied to the existing load port 900 by appropriately changing the connection structure with the tube 670, such as the shape of the first opening 617. For example, the solenoid valve 800 may be connected to the first opening 617, and the tube 670 may be connected to the second opening 618.

In addition, the shape of the cartridge 100 is an example, and the cartridge 100 may be configured not to include the boss parts 131 to 133, the housing part 121, the ventilation part 122, and the like. For example, a cartridge not including the boss parts 131 to 133 may be welded to the main body.

Moreover, in the embodiment described above, the configuration where the second opening 618 connected to the solenoid valve 800, the check valve 613, and the connection port 517 are arranged in a straight line is described, but the embodiment is not limited to this configuration. For example, the connection port 517 may be provided in a suction path from the check valve 613 to the vacuum pump 160, and the tube 670 may be connected to the suction space 600 forming from the check valve 613 to the second opening 618.

Note that the vacuum generator 10 illustrated in the embodiment can also be used for evacuation of other devices such as semiconductor manufacturing equipment other than the load port 900 and a vacuum molding device.

Although the present invention is described above based on the embodiment and each modified example, the present invention is not limited to the embodiment and each modified example, and it is obvious that various modifications can be made without departing from the scope of the present invention. The various modifications made without departing from such a scope are also included in the technical scope of the present invention, and this is apparent to those skilled in the art from the description of the claims.

### Reference Signs List

10 Vacuum generator, 100 Cartridge, 110 Cover, 111 Top surface, 120 Side surface, 121 Housing part, 122 Ventilation part, 130 Curved surface, 131 to 133 Boss part, 134, 135 Claw part, 136, 137 Exhaust port, 140 Bottom part, 141 to 143 Protruding part, 144, 145 Recessed part, 147, 148 Through hole, 149 Support part, 150 Bottom surface, 151 to 155, 159 Sidewall, 156 to 158 Through hole, 160 Vacuum pump, 161 Side surface, 164 Bottom surface, 167 Suction hole, 169 Discharge hole, 180 Terminal block, 181 to 185 Terminal, 189 Substrate, 191 to 193, 196 to 198 Bolt, 500 Mounting member, 501 Support surface, 502 Mounting surface, 510 Slot, 511 to 513 Support wall, 514, 515 Engaged part, 517 Connection port, 518 Connector, 519 Seal packing, 580 Substrate, 600 Suction space, 611 First space, 612 Second space, 613 Check valve, 614 Biasing member, 615 Vent hole, 617 First opening, 618 Second opening, 619, 671, 681 Sealing member, 670, 820 Tube, 700 Suction path, 800 Solenoid valve, 810 Atmosphere opening port, 900 Load port, 910 Wall part, 920 Table, 930 Interior space, 950 Opening/closing part, 951, 952 Suction part, 959 Pipe, 970 Pipe connection part

## Claims

1. A vacuum generator, comprising:
a mounting member; and
a suction device including a vacuum pump connected to the mounting member, wherein
the mounting member includes:
a suction space connecting the vacuum pump to a tube connected to a suction target; and
a solenoid valve enabling a suction path including the tube and the suction space to be open to an atmosphere.

2. The vacuum generator according to claim 1, wherein
the suction space includes a first space and a second space; and the vacuum generator comprises:
a check valve switchable between a communication state and a separation state of the first space and the second space of the suction space, wherein
the check valve is switched to the separation state in a state where the vacuum pump is stopped, and is switched to the communication state during operation of the vacuum pump.

3. The vacuum generator according to claim 2, comprising:
a biasing member configured to bias the check valve in a direction to bring the check valve into the separation state.

4. The vacuum generator according to claim 3, wherein
the suction device is removable from the mounting member, and
the check valve maintains the separation state even when the suction device is removeed from the mounting member.

5. The vacuum generator according to any one of claims 2 to 4, wherein
the suction space includes a first opening and a second opening,
the tube is connected to the first opening, and
the solenoid valve is connected to the second opening.

6. The vacuum generator according to claim 5, wherein
the second opening the solenoid valve is connected to, the check valve, and a connection port the vacuum pump is connected to are arranged in a straight line.

7. The vacuum generator according to claim 6, wherein
the connection port is in close contact with the suction space via a sealing member.

8. The vacuum generator according to claim 1, comprising:
a control unit configured to control starting and stopping of the vacuum pump and closing and opening of the solenoid valve.

9. A load port connected to the vacuum generator according to claim 1 via the tube, comprising:
a suction part connected to the tube, wherein
the suction device is removable in a state where the vacuum generator is connected to the tube.
